# EUROPEAN PATENT APPLICATION

(11) **EP 1 863 321 A1**
(43) Date of publication of application: **05.12.2007**
(21) Application number: 06714569.8
(22) Date of filing: 24.02.2006
(51) Int. Cl.: H05B 33/02, H05B 33/10, H05B 33/26, H05B 33/28

(54) **ORGANIC ELECTROLUMINESCENT ELEMENT AND METHOD FOR MANUFACTURING SAME**

(30) Priority: 25.02.2005 JP 2005051987
(71) Applicant: Nissan Motor Company Limited, Kanagawa-ku Yokohama-shi, Kanagawa 221-0023 (JP)
(72) Inventor: KUMAZAWA, Kinya c/o NISSAN MOTOR CO, LTD. IPDU, Kanagawa 243-0192 (JP); OKADA, Jun c/o NISSAN MOTOR CO, LTD. IPD, Kanagawa 243-0192 (JP); MORI, Tatsuo c/o NATIONAL UNIVERSITY CORP.NAGOYA UNIVERSITY,, Nagoya-shi Aichi 464-8601 (JP)
(74) Representative: Schaeberle, Steffen
(86) International application number: PCT/JP2006/303430
(87) International publication number: WO 2006/090838

(57) **Abstract**

An organic electroluminescent element 1 according to the present invention includes: a substrate 2; a first electrode 3 formed on the substrate; an organic light-emitting layer 5 formed on the first electrode 3 so as to be brought into contact with the first electrode 3; and a second electrode 6 formed on the organic light-emitting layer 5, **characterized in that** an ion-doped surface onto which hydrogen ions or hydroxide ions are doped as dopant is provided in the vicinity of a contact interface B between the first electrode 3 and the organic light-emitting layer 5. By such characteristics, an organic electroluminescent element can be obtained, in which a low-voltage drive is made possible, and a long lifetime is realized.

## Description

### TECHNICAL FIELD

The present invention relates to an organic electroluminescent element (organic EL element) and a manufacturing method thereof.

### BACKGROUND ART

Recent computerization and progress of the IT technology have been tremendous, and development of a luminescent element that emits light, a solar battery that absorbs light to subject the light to energy conversion, and further, liquid crystal-series and electrochromic-series light modulation elements in each of which a light transmittance is varied depending on ON-OFF of a voltage has been accelerated.

In each of these elements, an anode and a cathode are arranged on both surfaces thereof. In particular, when light is desired to be made incident onto or emitted from the element, a configuration is adopted, in which, by using a transparent electrode, light generated in the element is efficiently emitted to the outside, or light from the outside is made incident into the inside of the element.

Basically, the element represented by an organic EL element, the solar battery, the light modulation element, and a transistor element (FET element) allows the anode and the cathode to sandwich both surfaces of at least one type of functional thin film therebetween, and is composed as a sandwich type. When each element is viewed from a mechanical viewpoint, motion of charged carriers (electrons, holes) on interfaces between the two electrodes and the functional thin film, or on an interface between the functional thin film and the functional thin film, that is, on such an interface between different types of materials is positively utilized, and an electronic function or an optical function are exerted.

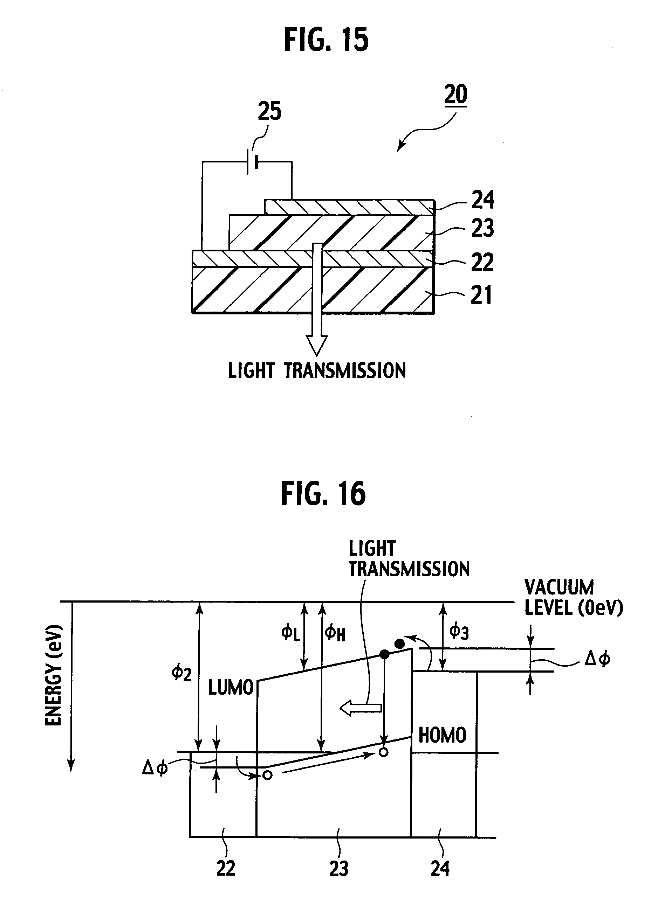

As an example of the above-described element, a description will be made below of an organic electroluminescent element that has got into the limelight recently. FIG. 15 shows a longitudinal cross-sectional view of an organic EL element. In the organic EL element 20, an anode 22 is formed on a transparent substrate 21, and a light-emitting layer 23 as the functional thin film and a cathode 24 are formed on the anode 22. Then, the anode 22 and the cathode 24 are individually connected to a positive electrode and negative electrode of a direct current power supply 25.

When a voltage is applied between the anode 22 and the cathode 24, holes from the anode 22 side, and further, electrons from the cathode 24 side are injected into the light-emitting layer 23 beyond heights Δø of potential barriers in the respective contact interfaces thereof. Then, a mechanism is formed, in which the injected electrons and holes are recombined in the light-emitting layer 23, and the light is thereby emitted. Then, the light thus emitted is emitted from the transparent substrate 21 side formed of a light transmitting material.

FIG. 16 shows a band structure schematically showing flows of the electrons and the holes in the organic EL element 20, and the potential barriers on the contact interfaces therein. In the structure shown in FIG. 16, a magnitude ø₂ of an ionization potential of the anode 22 is approximately 4.5 eV to 4.7 eV, and a magnitude ø_{H} of an ionization potential of the light-emitting layer 23 is approximately 5.4 eV to 5.8 eV. Accordingly, the height Δø of the potential barrier becomes as extremely large as approximately 0.7 eV to 1.3 eV. When the height Δø of the potential barrier becomes large, it becomes difficult for the holes to be injected from the anode 22, and in order to obtain target emission brightness, a high voltage cannot help but being applied between the anode 22 and the cathode 24. This has inhibited a low-voltage drive of the organic EL element 20. Moreover, when it becomes difficult for the holes to be injected, it becomes difficult to ensure an injection balance thereof with the electrons injected from the cathode 24. From this fact, stability of the light emission has not been able to be maintained. In order to solve the problems as described above, some approaches are made.

First, there is proposed a method of fixing the anode in advance, and inserting a buffer layer between the anode and the light-emitting layer, in which an ionization potential of the buffer layer is an intermediate value between both thereof (refer to "Talk About Organic EL (original title is in Japanese), p. 49, edited by Nikkan Kogyo Shimbun, Ltd.).

Second, there is proposed a method of fixing the anode in advance, and selecting a light-emitting layer of which magnitude of the ionization potential is relatively close to the magnitude of the ionization potential ø₂ of the anode.

Third, there is proposed a method of fixing the light-emitting layer in advance, and selecting an anode of which magnitude of the ionization potential is relatively close to the magnitude ø_{H} of the ionization potential of the light-emitting layer.

### DISCLOSURE OF INVENTION

However, the above-described three methods have individually had problems.

In the first method, when the buffer layer is inserted, such an energy difference between the anode and the light-emitting layer can be varied in stages. Accordingly, as for the anode side, the holes as carriers thereof can easily go beyond the height Δø of the potential barrier. However, the magnitude ø of the ionization potential of the buffer layer cannot be arbitrarily controlled, and in addition, processes caused by coating and curing the buffer layer concerned are also increased, resulting in rising of cost. Accordingly, the first method has not been practical.

The second method has had a problem in that, when a light-emitting material is selected while focusing on the magnitude ø of the ionization potential, an emission color cannot be freely selected, or high light emission efficiency cannot be obtained, either.

In the third method, it has been extremely difficult to select such an anode of which magnitude of the ionization potential is close to the magnitude ø_{H} of the ionization potential of the light-emitting layer while satisfying low resistance, high light transmittance, electrode pattern formability such as etching property, and surface flatness, which are required for the anode. In addition, besides an ITO (Indium Tin Oxide) electrode that is most commonly used, as the anode for which transparent conductivity is required, electrodes of ATO (Antimony doped Tin Oxide), FTO (Fluorine doped Tin Oxide), ZnO (Zinc Oxide) are known; however, these electrodes have also had similar problems to those of the ITO electrode.

It has been desired to develop a functional element in which the height ø of the potential barrier on the contact interface between the anode and the cathode or the light-emitting layer is controlled as described above, and to make a display using the functional element commercially viable. However, in actual, based on physical values (ionization potentials) intrinsic to metal and oxide semiconductors, and further, to the functional thin film, the respective layers have not been able to help but being used in combination.

Moreover, as a conventional technology, there has been disclosed an organic EL element having a chemical doping layer in which a compound having property as a Lewis acid is doped into an organic compound is provided between the anode and the light-emitting layer (refer to Japanese Patent Unexamined Publication No. 2001-244079). However, since a process of providing the chemical doping layer is increased in the manufacturing process, this results in the rising of cost in a similar way to the above-described first method, and the disclosed organic EL element has not been practical. Moreover, in Japanese Patent Unexamined Publication No. 2001-244079, a configuration is adopted, in which a third layer (chemical doping layer) is provided between an anode layer and a hole transport layer. When the third layer as described above is formed, this does not contribute to a resistance decrease of the element at all, but on the contrary, there is a possibility that the third layer may function as a series resistor, and resistance between the anode layer and the hole transport layer may be increased. Moreover, there is also a possibility that the presence of the third layer may bring a decrease of the light transmittance. The decrease of the light transmittance leads to an optical loss when the light generated in the light-emitting layer is emitted to the outside through the anode transparent electrode and the transparent substrate, thereby causing a decrease of the emission brightness.

The present invention has been made in order to solve the above-described problems. It is an object of the present invention to provide an organic EL element that realizes the low-voltage drive and a long lifetime, and to provide a manufacturing method of the organic EL element, in which a manufacturing process is simple, and further, a cost reduction is achieved.

An organic electroluminescent element according to a first aspect of the present invention, includes: a substrate; a first electrode formed on the substrate; an organic light-emitting layer formed on the first electrode to be brought into contact with the first electrode; and a second electrode formed on the organic light-emitting layer, characterized in that an ion-doped surface onto which hydrogen ions or hydroxide ions are doped as dopant is provided in a vicinity of a contact interface between the first electrode and the organic light-emitting layer.

A manufacturing method of an organic electroluminescent element according to a second aspect of the present invention, includes the steps of: forming a first electrode on a substrate; adhering an aqueous solution containing hydrogen ions or hydroxide ions onto the first electrode, and doping the hydrogen ions or the hydroxide ions onto a surface of the first electrode; forming an organic light-emitting layer on the surface of the first electrode, onto which the hydrogen ions or the hydroxide ions are doped; and forming a second electrode on the organic light-emitting layer, characterized in that, when the hydrogen ions are doped onto molecules on the contact interface, negatively charged anions are adsorbed onto a surface of the first electrode, and an electric double layer is thereby formed, and when the hydroxide ions are doped onto the molecules on the contact interface, a concentration of the hydroxide ions is increased, and an ionization potential of the first electrode is thereby decreased.

A surface treatment method according to a third aspect of the present invention is characterized in that an electrode is immersed into an acidic solution containing hydrogen ions or into an alkaline solution containing hydroxide ions, the hydrogen ions or the hydroxide ions are doped onto a surface of the electrode, and an ionization potential of the surface of the electrode is thereby controlled.

### BRIEF DESCRIPTION OF THE DRAWINGS

FIG. 1 is a longitudinal cross-sectional view of an organic EL element according to an embodiment of the present invention.
FIG. 2 is a view showing a band structure when an ITO electrode is used as an anode, and PPV (polyphenylenevinylene) is used as an organic light-emitting layer.
FIGS. 3(a) to 3(c) are views showing states of the anode when hydrogen ions are doped onto a surface of the anode of the organic EL element according to the embodiment of the present invention: FIG. 3(a) is a view showing a state of the anode in an untreated state; FIG. 3(b) is a view showing a state where the hydrogen ions are doped onto the surface of the anode; and FIG. 3(c) is a view showing a state where an electric double layer is formed on the surface of the anode.
FIG. 4 is a view showing a mechanism of an ionization potential change by acidic solution treatment.
FIG. 5(a) is an explanatory view explaining how to measure photoelectrons flying out of the surface of the anode; and FIG. 5(b) is an explanatory view explaining how to measure ionization potentials on the surface of the anode.
FIG. 6 is an enlarged view for explaining the ion-doped surface.
FIG. 7 is a longitudinal cross-sectional view of an organic EL element according to another embodiment in the present invention.
FIG. 8 is a graph showing data obtained by measuring an ionization potential Ip₂ on the surface of the electrode when H₂SO₄ and HCl are used as acidic solutions, and further, concentrations thereof at the time of the acidic solution treatment are changed.
FIG. 9 is a graph showing a relationship between the ionization potential and an acidic solution treatment time.
FIG. 10 is a graph showing a relationship between pH and surface resistivity.
FIG. 11 is a view showing XPS spectra on a surface of the PEDOT:PSS electrode after the PEDOT:PSS electrode is subjected to acidic treatment or alkaline treatment.
FIG. 12 is a view showing data in the case of analyzing an inside of the PEDOT:PSS electrode by TOF-SIMS (Time of Fright - Secondary Ion Mass Spectroscopy).
FIGS. 13(a) to 13(c) are schematic views for explaining a decrease of the surface resistivity owing to the acidic solution treatment; FIG. 13(a) shows a carrier transport in a molecule: FIG. 13(b) shows a carrier transport between molecules; and FIG. 13(c) shows a carrier transport between particles.
FIG. 14 is a graph showing data obtained by measuring an ionization potential Ip₃ on the surface of the electrode when NaOH and NH₃ are used as the acidic solutions, and further, concentrations thereof at the time of the alkaline treatment are changed.
FIG. 15 is a longitudinal cross-sectional view of a conventional organic EL element.
FIG. 16 is a view showing a band structure schematically showing flows of electrons and holes of the conventional organic EL element and potential barriers on bonded interfaces.

### BEST MODE FOR CARRYING OUT THE INVENTION

### (Organic EL element)

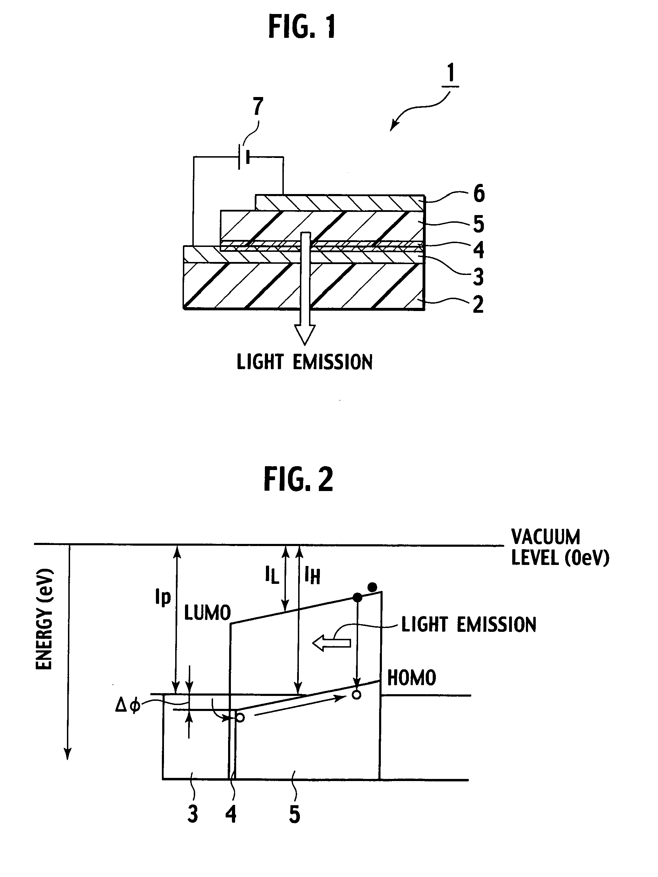

An organic EL element 1 according to an embodiment of the present invention is shown in FIG. 1. The organic EL element 1 includes: a substrate 2; an anode 3 formed on the substrate 2; an organic light-emitting layer 5 formed on the anode 3; and a cathode formed on the organic light-emitting layer 5. Moreover, the anode 3 and the cathode 6 are connected to a positive electrode and negative electrode of a direct current power supply 7, respectively. When the substrate 2 and the anode 3 are composed of materials having light transmittance, emission light generated in the organic light-emitting layer 5 is emitted after transmitting through the anode 3 and the substrate 2.

Then, the present invention is characterized in that an ion-doped surface (by an amount of several molecules) 4 onto which hydrogen ions (H⁺) are doped as dopant is provided in the vicinity of an interface formed in such a manner that the anode 3 and the organic light-emitting layer 5 are brought into contact with each other. As described above, the ion-doped surface 4 is formed on the contact interface between the anode 3 and the organic light-emitting layer 5, and a concentration of the hydrogen ions in the vicinity of the contact interface is increased. In such a way, an ionization potential of the anode 3 is increased, and when viewed from a hole side, a potential barrier ø of the contact interface between the anode 3 and the organic light-emitting layer 5 is lowered.

In FIG. 2, a band structure in the case of using ITO (Indium Tin Oxide) as the anode 3 and using PPV (polyphenylenevinylene) as a material of the organic light-emitting layer 5 is schematically shown.

In accordance with a document, the ionization potential ø₂ of the ITO electrode (anode 3) is approximately 4.5 eV to 4.7 eV, and an ionization potential of the PPC (organic light-emitting layer 5) is approximately 5.2 eV to 5.5 eV. When a consideration is made based on both values, the potential barrier ø of the contact interface between the anode 3 and the organic light-emitting layer 5 is estimated to be 0.5 eV to 1.0 eV. When a large potential barrier ø occurs on the contact interface between the anode 3 and the organic light-emitting layer 5, in order to obtain desired emission brightness, a high voltage must be applied between the anode 3 and the cathode 6, and holes or electrons must be injected positively. However, when the high voltage is applied between the anode 3 and the cathode 6, light emission stability and an emission lifetime in the organic light-emitting layer 5 are decreased, and the organic light-emitting layer 5 cannot reach a practical level. However, it is considered that, as in the present invention, the ion-doped surface 4 onto which the hydrogen ions (H⁺) are doped is formed on the contact interface between the anode 3 and the organic light-emitting layer 5, whereby a value of the ionization potential ø₂ of the anode 3 is increased, and the emission brightness and the emission lifetime are enhanced. Note that the term "ionization potential" is used for the ITO as the material of the anode 3, and the ionization potential is defined to be energy necessary to take out the electrons from a neutral atom to the outside. Note that the ITO is a semiconductor, and in a strict sense, it is appropriate to use therefor not the "ionization potential" but a term "work function". However, since both of the terms have basically the same conception, the term "ionization potential" is used here.

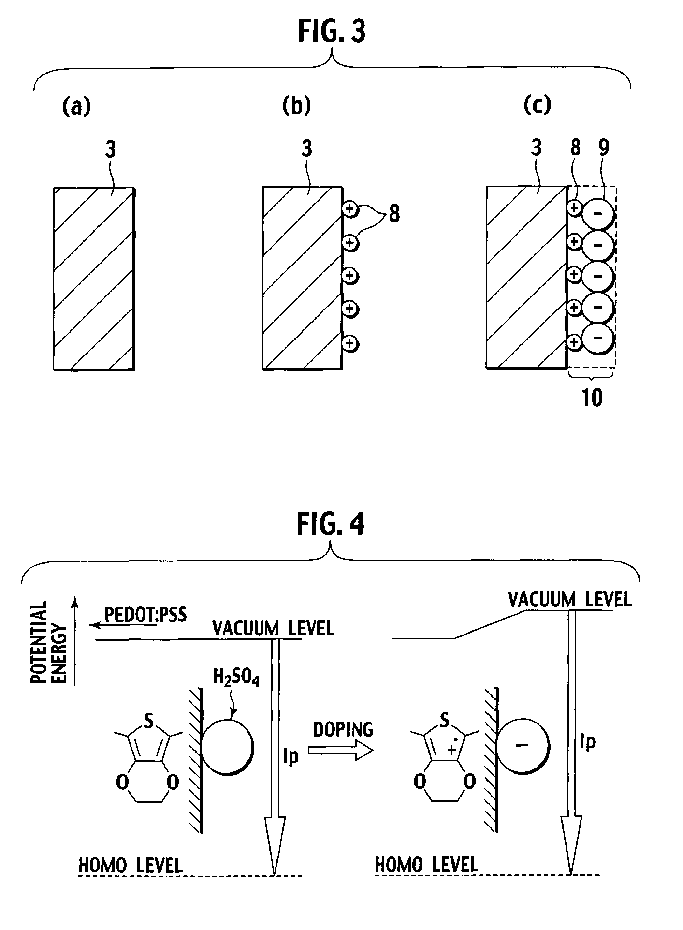

Next, a description will be made of functions and effects when the hydrogen ions (H⁺) are doped onto the surface of the anode 3 based on FIGS. 3(a) to 3(c) and 4. Note that, as a method of doping the hydrogen ions (H⁺), a description will be made of examples where samples are appropriately immersed into various acidic solutions containing the hydrogen ions (H⁺).

First, a description will be made of the reason that an ionization potential Ip₂ of the anode 2 is increased when a surface of each sample is immersed into the acidic solution and the hydrogen ions (H⁺) are doped thereonto. Note that, though the reason is not clear at present, it is considered that the above-described phenomenon of increase occurs based on the following mechanism. Moreover, though the ionization potential of the electrode is expressed as Ip in the band structure shown in FIG. 2, the ionization potential is expressed as Ip₂ here in the meaning of the ionization potential after the hydrogen ion doping by the acidic treatment. Moreover, as an example of an electrode material, a description will be made of polyethylenedioxythiophene (PEDOT):polystyrene sulfonate (PSS) (PEDOT:PSS) as one of π-conjugated substances.

In FIG. 3, states before and after the case of doping the hydrogen ions (H⁺) onto the surface of the electrode (anode 3) by acidic solution treatment are shown. The surface of the anode 3 in an untreated state is shown in FIG. 3(a), and a state where the hydrogen ions (H⁺) are doped onto the surface of the anode 3 is shown in FIG. 3(b). When the hydrogen ions (H⁺) 8 are doped onto the surface of the anode 3, and a concentration of the hydrogen ions on the surface of the anode 3 is increased, a state is brought, where electric stability on the surface of the anode 3 becomes insufficient. Accordingly, for the purpose of maintaining electric neutrality, anions 9 negatively charged are induced, and an electric double layer 10 is formed on the surface of the anode 3. This state is shown in FIG. 3(c). When the electric double layer 10 is formed on the surface of the anode 3, a probability that the electrons present in the anode 3 are mutually repelled is increased owing to the presence of the anions 9 located on the outermost surface, and it becomes difficult for the electrons to be emitted to the outside. Specifically, it is guessed that a value of the ionization potential of the anode 3 after the doping treatment of the hydrogen ions (H⁺) is increased in comparison with that of the ionization potential of the anode 3 in the untreated state.

A description will be specifically made of the examination in FIG. 3 by using a model of the case of using PEDOT:PSS as the electrode material, and further, using H₂SO₄ as the acidic solution. As shown in FIG. 4, if a PEDOT molecule in a PEDOT:PSS composite is doped with H₂SO₄, then an inside of the PEDOT molecule is positively charged. Meanwhile, an outside of the PEDOT molecule is negatively charged, and the electric double layer is resultantly formed, and therefore, it is considered that the ionization potential is increased.

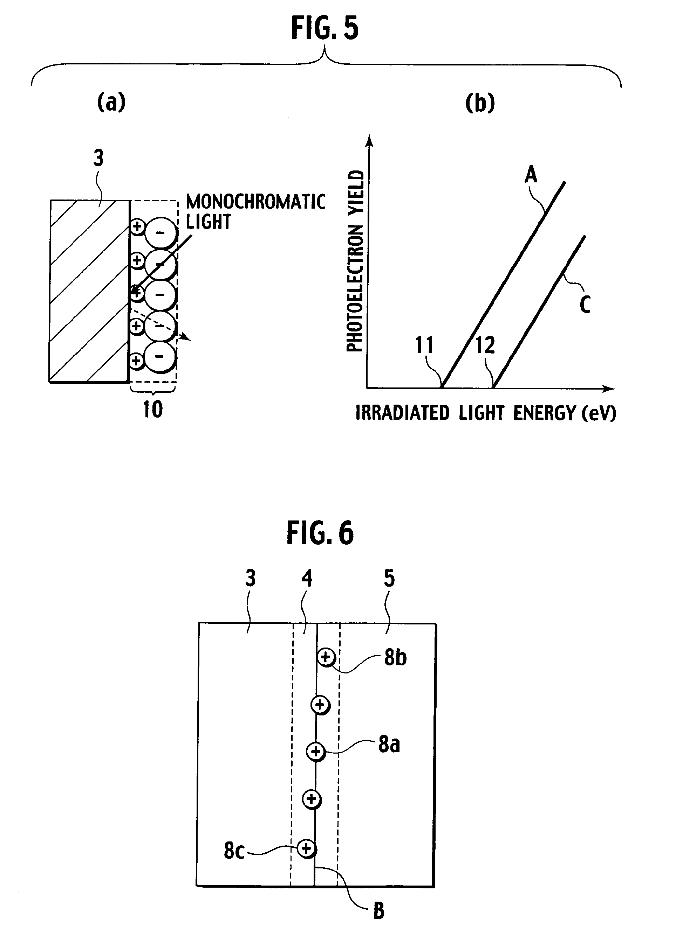

By using a photoelectric spectrometer (AC-2, made by Riken Keiki Co., Ltd.), the ionization potential of the surface of the anode 3, on which the hydrogen ions (H⁺) are doped and the electric double layer 10 is formed, can be measured in the atmosphere. As shown in FIG 5(a), a wavelength of monochromatic light is made incident onto the surface of the anode 3, the wavelength (in other words, irradiation energy) of the monochromatic light is varied, and photoelectrons are made to fly out of the surface of the anode 3. Such photoelectrons are measured by a counter (not shown). Then, a state is brought, where the photoelectrons are emitted steeply from a certain threshold value. A measurement principle diagram of the ionization potential of the surface of the anode 3 is shown in FIG. 5(b). A straight line A indicates plots of the photoelectrons on the surface of the anode 3 in the untreated state, which is shown in FIG. 3(a). A straight line C indicates plots of the photoelectrons in a state where the hydrogen ions (H⁺) are doped to form the ion-doped surface 4, and the electric double layer 10 is formed on the surface of the anode 3 as shown in FIG. 3(c). An axis of abscissas represents irradiated light energy (eV), and an axis of ordinates represents 1/2 power of a photoelectron yield. Intersections 11 and 12 where the straight lines A and C intersect the irradiated light energy on the axis of abscissas become values of the ionization potentials. The value of the ionization potential of the straight line A is 4.7 eV, and the value of the ionization potential of the straight line C is 5.2 eV. As shown by the straight line C, it has been proven that the value of the ionization potential is increased when the ion-doped surface 4 in which the hydrogen ions (H⁺) are doped onto the surface of the anode 3 is formed. Hence, as shown in FIG. 5(b), it is considered that the value of the ionization potential Ip₂ is increased more than a magnitude Ip₁ of the ionization potential of the surface of the anode 3 in the untreated state owing to effects of the anions induced by doping the hydrogen ions (H⁺), and of the electric double layer formed of both thereof. Specifically, in the present invention, when the ionization potential of the electrode surface onto which the hydrogen ions as the dopant are not doped is defined as Ip₁, and the ionization potential of the electrode surface onto which the hydrogen ions are doped is defined as Ip₂, a difference Ip₂-Ip₁ between both thereof becomes larger than 0.

Note that, on the above-described ion-doped surface 4, as shown in FIG. 6, the hydrogen ions 8 are present in the vicinity of the contact interface B of the anode 3 and the organic light-emitting layer 5. Specifically, the hydrogen ions 8 can be sometimes present on the contact interface B as denoted by reference numeral 8a, can be sometimes mainly present in the organic light-emitting layer 5 as denoted by reference numeral 8b, and further, can be mainly present in the anode 3 as denoted by reference numeral 8c. However, in the present invention, if a state is where the hydrogen ions 8 are in contact with the contact interface B, the ionization potential of the anode 3 can be increased.

The description has been made above of the organic EL element 1 in which the hydrogen ions are doped in the vicinity of the interface between the anode 3 and the organic light-emitting layer 5, whereby the ion-doped surface 4 is formed. However, in the present invention, an ion-doped surface in which hydroxide ions are doped onto an interface between the cathode and the organic light-emitting layer may be formed.

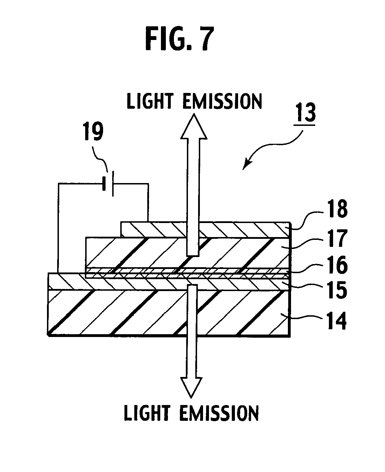

A longitudinal cross-sectional view of the organic EL element 13 in which the hydroxide ions are doped onto the contact interface between the cathode and the organic light-emitting layer is shown in FIG. 7. The organic EL element 13 includes: a substrate 14; a cathode 15 formed on the substrate 14; an organic light-emitting layer 17 formed on the cathode 15; and an anode 18 formed on the organic light-emitting layer 17. Moreover, the cathode 15 and the anode 18 are connected to a negative electrode and positive electrode of a direct current power supply 19, respectively. When the substrate 14, the cathode 15, and the anode 18 are composed of materials having light transmittance, emission light generated in the organic light-emitting layer 17 can be emitted from both surface sides of the organic EL element 13.

Then, in the present invention, an ion-doped surface (by an amount of several molecules) 16 onto which the hydroxide ions (OH-) are doped as the dopant may be provided in the vicinity of an interface formed in such a manner that the cathode 15 and the organic light-emitting layer 17 are brought into contact with each other. As described above, the ion-doped surface 16 onto which the hydroxide ions are doped is formed on the contact interface between the cathode 15 and the organic light-emitting layer 17, and a concentration of the hydroxide ions in the vicinity of the contact interface is increased. In such a way, an ionization potential of the cathode 15 is decreased, and a potential barrier ø of the contact interface between the cathode 15 and the organic light-emitting layer 17 is lowered. Note that, in a similar way to the hydrogen ions shown in FIG. 6, if a state is where the hydroxide ions are in contact with the contact interface between the cathode 15 and the organic light-emitting layer 17, then the ionization potential of the cathode 15 can be decreased.

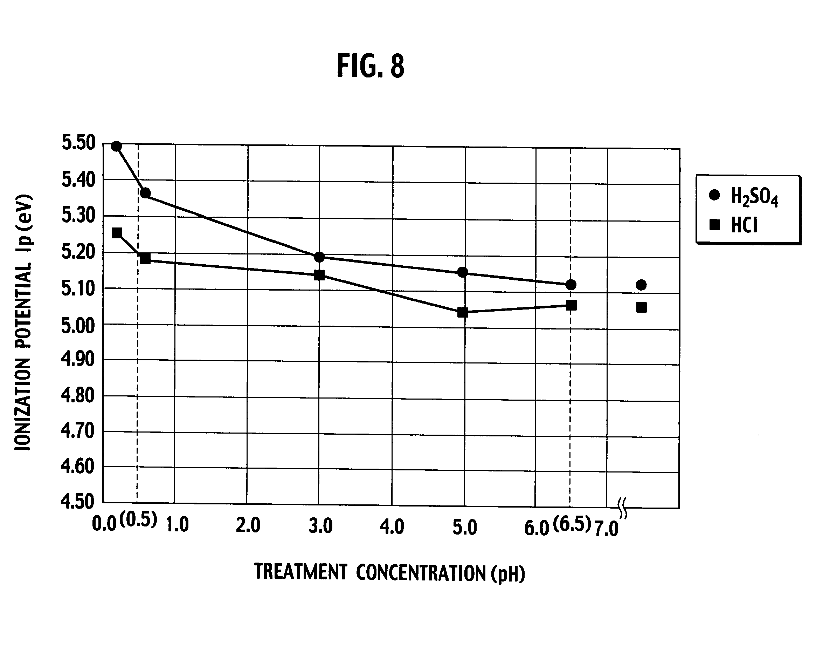

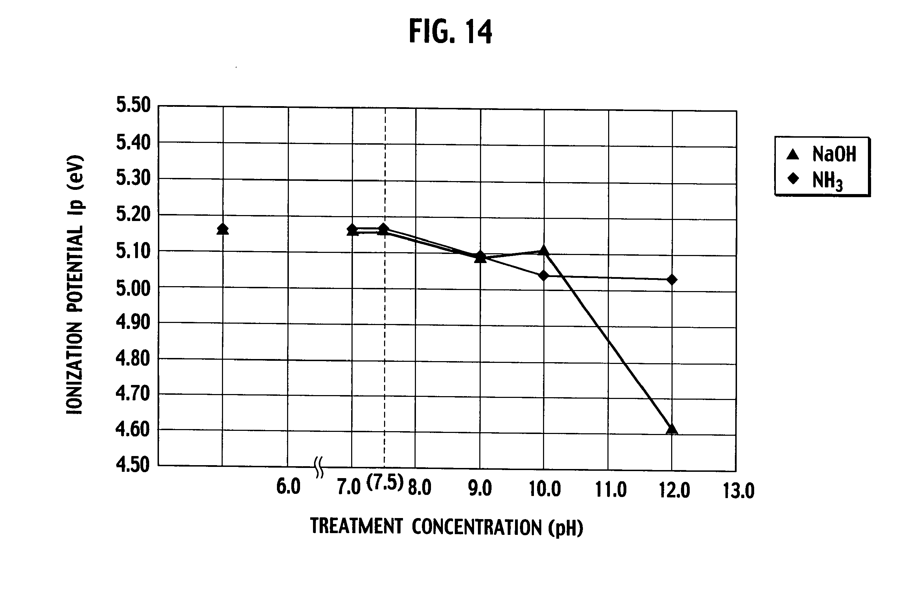

Next, a description will be specifically made of changes of the ionization potential Ip when the treatment is performed by using several types of acidic solutions or alkaline solutions based on FIG. 8 and FIG. 14.

Data obtained by measuring the ionization potential Ip₂ on the surface of the electrode (PEDOT:PSS) when PEDOT:PSS is used as the electrode, H₂SO₄ and HCl are used as the acidic solutions, and treatment concentrations at the time of the acidic treatment are changed is shown in FIG. 8. Note that a treatment temperature at this time was set at the room temperature, and a processing time was set at 600 seconds. Moreover, the ionization potential in the atmosphere was measured by using the photoelectric spectrometer (AC-2, made by Riken Keiki Co., Ltd.).

As shown in FIG. 8, when H₂SO₄ or HCl was used as the acidic solution, it turned out that, as the solution concentration (pH) on an axis of abscissas was becoming lower, and acidity of the solution was becoming stronger, a value of the ionization potential Ip₂ became larger. In particular, in the present invention, it is preferable that the concentration (pH) of the acidic solution be set within a range of 6.5 to 0.5. This is because, when the concentration (pH) of the acidic solution becomes less than 0.5, and the acidity thereof becomes too strong, film quality of the electrode or the organic light-emitting layer becomes inferior, and this is not preferable in practical use. On the contrary, this is because a difference does not occur with an electrode in the untreated state, which is not subjected to the acidic treatment, when the concentration (pH) of the acidic solution exceeds 6.5.

Moreover, as shown in FIG. 8, in the case where the solution concentrations (pH) of H₂SO₄ and HCl as the acidic solutions were set the same, when the acidic treatment was performed by using H₂SO₄ rather than HCl, the value of the ionization potential showed a tendency to become larger. Although the reason for this is not clear, it is considered that a size and quantity of the induced anions differ depending on the types of the acidic solutions for use, and an effect of the electric double layer also differs.

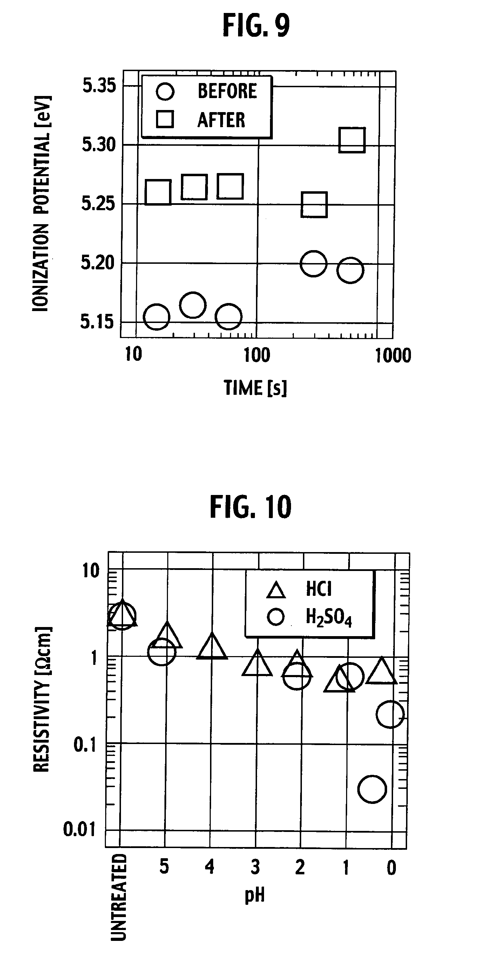

Moreover, besides to the concentration (pH) at the time of the acidic solution treatment, the value of the ionization potential is varied also in response to the treatment temperature and the treatment time, which become factors to control the ion doping. Since the value of the ionization potential is varied in response to the treatment time or the treatment temperature, it is necessary to appropriately set the respective conditions in order to obtain a desired ionization potential. In FIG. 9, a relationship between the ionization potential and an immersion treatment time when a PEDOT:PSS thin film is used as the electrode material, and H₂SO₄ (pH=0.5) is used as the acidic solution is shown. In this case, as apparent also from FIG. 9, it is understood that the value of the ionization potential becomes constant at approximately 5.25 eV within a time range from several ten seconds to several hundred seconds. As described above, the treatment method of the present invention has a feature in that such a stable value of the ionization potential can be obtained in a relatively short time. Moreover, when the temperature at the time of the acidic solution treatment becomes too high, there is a possibility that the ion doping may be accelerated, and may be uncontrollable only by the treatment time. Accordingly, preferably, the treatment temperature is set within a range of the room temperature (approximately 25°C) to 40°C, more preferably, at around the room temperature.

Note that, though the example of using H₂SO₄ and HCl as the acidic solutions has been mentioned in FIG. 8, it was confirmed that a similar tendency was shown also in the case of using, as the acidic solution, a proton acid (HNO₃, HF, HClO₃, FSO3H, CH₃SO₃H, or the like) or a Lewis acid solution (BF₃, PF₅, AsF₅, SbF₅, SO₃, or the like) besides the above.

Specifically, the organic electroluminescent element of the present invention includes the ion-doped surface onto which the hydrogen ions are doped as the dopant, and can select the proton acid, the Lewis acid, and a mixture thereof as the hydrogen ions. Then, preferably, the proton acid is at least one selected from among H₂SO₄, HCl, HNO₃, HF, HClO₃, FSO₃H, and CH₃SO₃H, and the Lewis acid is at least one selected form among BF₃, PF₅, AsF₅, SbF₅, and SO₃.

Moreover, it turned out that, when the surface of the electrode or the surface of the organic light-emitting layer was subjected to the acidic solution treatment to dope the hydrogen ions (H⁺) thereonto, surface resistivity of the surface of the electrode or of the organic light-emitting layer became small. Specifically, as shown in FIG. 10, when the acidic treatment was implemented for the PEDOT:PSS thin film electrode under the room temperature by using, for example, an H₂SO₄ solution or an HCl solution, the surface resistivity R becomes smaller as the treatment concentration pH is becoming smaller from 5 to 0.5 in both of the cases. Specifically, with regard to the surface resistivity R around where pH is 0.5, the surface resistivity R was decreased to approximately 1/100 of that in an initial stage in the H₂SO₄ solution treatment, and was decreased to approximately 1/10 of that in an initial stage in the HCl solution treatment. As described above, though behaviors of the treatment by the H₂SO₄ solution and the treatment by the HCl solution somewhat differ from each other, the surface resistivities R become smaller as pH is becoming smaller in both of the treatments. Note that the 4-point probe method is employed for the surface resistivity. Although a phenomenon mechanism of the above remains uncertain, the phenomenon mechanism is considered as below at present.

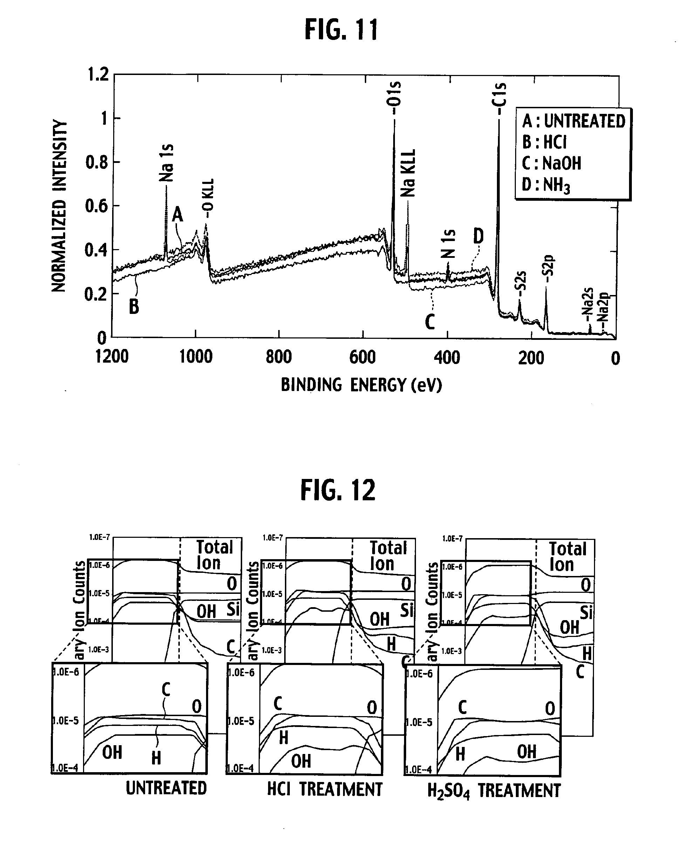

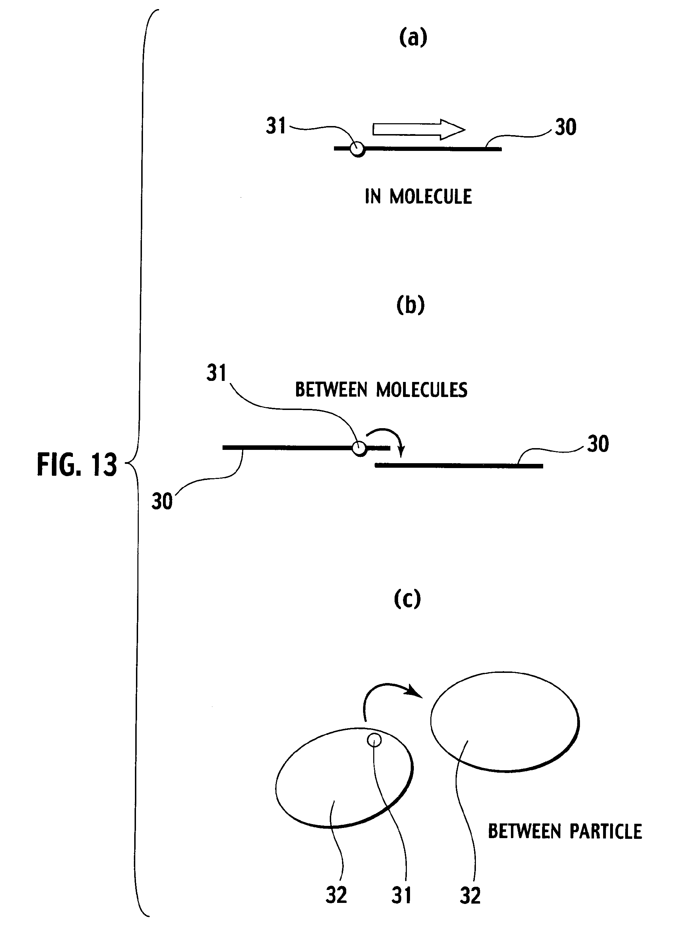

From a result that strengths of OH and O in the inside of the electrode film are lowered, which is obtained by the data of FIG. 10, an AFM image (Atomic Force Microscope image), XPS (X-ray Photoelectron Spectroscopy) spectra of FIG. 11, and TOF-SIMS (Time of Fright - Secondary Ion Mass Spectroscopy) of FIG. 12, it is considered that, when the concentration pH of the acidic solution treatment is reduced, the following may occur: (1) an effect of removing impurities present on the surface of the electrode or on the surface of the organic light-emitting layer becomes more significant; or (2) secondary doping into the molecules occurs. It is guessed that a carrier transport contributing to the lower surface resistivity R is promoted by this function. Mechanism images of the above are described in FIGS. 13(a) to 13(c). Specifically, it is considered that a transport of a carrier 31 is promoted in such a manner that not only the surface of the electrode but also an inside of the PEDOT:PSS molecule 30 are doped as shown in FIG. 13(a). Moreover, it is considered that transports of the carriers 31 between the PEDOT:PSS molecules 30 and between PEDOT:PSS particles 32 are also promoted as shown in FIG. 13(b) and 13(c).

From the above-described points, it is considered that this phenomenon emerges in such a manner that the ions are directly doped onto the surface of the electrode or the surface of the organic light-emitting layer. Moreover, a configuration is adopted, in which the ions are directly doped, and more specifically, a configuration is adopted, in which a third layer is not present as in the conventional technology, and therefore, is not detected as an obvious layer thickness. In such a way, the decrease of the light transmittance within the visible light range is not recognized, either, and a merit is also generated, that the electrode or the organic light-emitting layer is usable as a transparent conductive film or a transparent electrode.

Note that the invention described in Japanese Patent Unexamined Publication No. 2001-244079 is one including a separate (independent) ion-doped layer from the functional thin film, in which the ion-doped layer is stacked on the functional thin film. Specifically, in Japanese Patent Unexamined Publication No. 2001-244079, it is described that the chemical doping layer is formed of an evaporation film or a solution coating layer, that a thickness thereof is 50 angstrom or more, and so on, in which the chemical doping layer is formed as a separate body from the light-emitting layer. When the chemical doping layer becomes the independent layer as described above, there occur such problems that a thickness of the stacked body is increased, and that the electric resistance is increased by an increase of the interface. Meanwhile, the invention of this application is one to dope the hydrogen ions or the hydroxide ions onto the molecules on the contact interface. Therefore, unlike the invention described in Japanese Patent Unexamined Publication No. 2001-244079, according to the present invention, functions and effects will be exerted, that the thickness of the functional thin film can be thinned, and the surface resistivity of the functional thin film can be reduced.

Next, a description will be made of the case of doping the hydroxide ions (OH⁻) by implementing the treatment by using the alkaline solution.

Data obtained by measuring the ionization potential Ip₂ on the surface of the electrode (PEDOT:PSS) when PEDOT:PSS is used as the electrode, NaOH and NH₃ are used as the alkaline solutions, and treatment concentrations at the time of the alkaline treatment are changed is shown in FIG. 14. Note that a treatment temperature at this time was set at the room temperature (approximately 25°C), and a processing time was set at 15 seconds. Moreover, the ionization potential was measured by using the photoelectric spectrometer (AC-2, made by Riken Keiki Co., Ltd.) in the atmosphere.

As shown in FIG. 14, when NaOH or NH₃ was used as the alkaline solution, as the solution concentration (pH) on an axis of abscissas was becoming larger, and alkalinity of the solution was becoming stronger, a value of the ionization potential Ip became smaller. In particular, in the case where the treatment was performed by using NaOH, when the value of pH was 12, the value of the ionization potential Ip showed a tendency to steeply become small. Moreover, the treatment concentration (pH) of the alkaline solution can be basically set within a range of 7.0 to 14.0; however, preferably, is set within a range of 7.5 to 12.0. This is because, when the value of pH goes out of the above-described range, there is an apprehension that the film quality of the electrode or the organic light-emitting layer may become inferior, and this is not preferable in practical use. It is necessary to select the practical treatment concentration (pH) in consideration for a molecular structure of the electrode material or the organic light-emitting layer material, and it is preferable that the treatment concentration not be too high. Note that it was confirmed that a substantially similar tendency was shown also in the case of performing the alkaline solution treatment by using KOH other than NaOH and NH₃.

Moreover, it turned out that, when the concentration (pH) was increased to make the alkalinity strong in this solution treatment, the surface resistivity R of the surface of the electrode or the surface of the light-emitting layer became large. Although a mechanism of the above is not clear, either, this is probably considered to be because, when the treatment concentration is increased, the molecular structure of the electrode material itself or the organic light-emitting layer material itself is changed. Specifically, this is considered to be because, in the case of performing the NaOH treatment, Na is bonded to a terminal end of the molecular structure of the electrode or the organic light-emitting layer, whereby the molecular structure is changed.

Moreover, when the ionization potential of the electrode surface onto which the hydroxide ions as the dopant are not doped is defined as Ip₁, and the ionization potential of the electrode surface onto which the hydroxide ions are doped is defined as Ip₃, it is preferable that a difference Ip₃-Ip₁ between both thereof become smaller than 0. This means that the treatment using the alkaline solution reduces the ionization potential Ip₃ of the electrode surface after the treatment more than the ionization potential Iₚ₁ of the electrode surface before the treatment. Accordingly, a merit is generated, that the ionization potential of the cathode itself of the organic EL element can be arbitrarily controlled.

Next, a description will be made of composition materials of the organic EL elements 1 and 13.

As the electrodes (anodes and cathodes), it is preferable to use transparent electrodes in which an average light transmittance in the visible light range is 60% or more. In the case of using the transparent electrodes, it becomes possible for the organic EL elements to easily emit the light. As such transparent electrodes, a metal thin film, an oxide semiconductor, and an organic material thin film, which are to be shown below, can be mentioned. Note that, while the electrode material just needs to be selected in response to the usage purpose, low resistance can be obtained even under the room temperature (25°C) in accordance with these transparent electrodes.

The metal thin film has a reflection peak (plasma reflection) intrinsic to the metal in the visible light range, and accordingly, does not always have high transparency. However, the metal thin film is low in resistance and excellent in stability, and accordingly, is frequently applied to a region brought by a high added value. As a material of the metal thin film, there can be mentioned at least one selected from among Au, Ag, Cu, Ni, Cr, Zn, In, Al, Sn, Pb, Pt, Pd, Ti, and mixtures thereof. From among those as illustrated above, it is preferable to select Au, Ag, Cu, or Pt from a viewpoint of the practical use. Note that it is possible to form the metal thin film by using the vacuum evaporation, the electron beam evaporation, the ion plating, or the sputtering method.

As the oxide thin film, it is preferable to use at least one selected from among inorganic oxides of tin oxide (SnO₂), indium tin oxide (ITO), and zinc oxide (ZnO), and composites thereof, which is excellent in balance between the transparency and the specific resistance in the visible light range. Among them, ITO is widely used as the transparent electrode. This is because ITO is low in surface resistance and high in light transmittance, and further, it is easy to form a circuit pattern thereon by etching. On the contrary, ITO having such excellent property has a large disadvantage as will be described below. Since ITO is a ceramic thin film, flexibility thereof is insufficient. Moreover, it is difficult to form the ITO thin film on an organic material or an organic thin film, which is inferior in heat resistance, and accordingly, ITO cannot sometimes be composed as an element. Moreover, the ITO thin film is formed by mainly using the vacuum process (for example, the sputtering method, the ion plating method, the evaporation method, and the like), and accordingly, a deposition rate thereof is slow, and in addition, a large capital investment becomes necessary, and the rising of cost is inevitable. Accordingly, as the electrode, it is preferable to use an organic material thin film to be described below.

As the organic material thin film, it is preferable to use a thin film of a π-conjugated substance. In accordance with the π-conjugated substance, the low surface resistance and the high light transmittance can be made compatible with each other by a function of π electrons in a conjugated double bond. Such π-conjugated substances are broadly classified into ones with low molecular weights and ones with high molecular weights in accordance with molecular weights thereof, and just need to be appropriately selected in response to the configuration of the element or the deposition process.

As such low-molecular-weight π-conjugated substances, there can be mentioned at least one selected from porphyrin, phthalocyanine, triphenylamine, quinacridon, and derivatives thereof. Phthalocyanine may be one that does not contain metal, or may be a complex with copper, magnesium, or the like.

As such high-molecular-weight π-conjugated substances, there can be mentioned at least one selected from polypyrrole, polyacetylene, polyaniline, polythiophene, polyisothianaphthene, polyflan, polyselenophene, polytellurophene, polythiephene vinylene, polyparaphenylene vinylene, and derivatives thereof. Moreover, from a viewpoint of enhancing the conductivity, it is preferable to use a material in which the doping treatment is implemented for a π-conjugated polymer. In such a way, the material is low in resistance and excellent in light transmittance, and further, can exhibit desired optical functions such as color emission and photoelectromotive force.

Furthermore, as the organic material thin film, there may be used at least one selected from among polyethylenedioxythiophene (PEDOT), polypropylene oxide (PO), and derivatives thereof, which are soluble in water or an organic solvent. In such a way, it is easy to handle the organic material thin film, and in addition, it becomes easy to appropriately use a variety of printing methods therefor. In particular, polyethylenedioxythiophene (PEDOT):polystyrene sulfonate (PSS) among polyethylenedioxythiophenes (PEDOTs) functionally combines the low surface resistivity R and the high transmittance, and is soluble in the water or the organic solvent to be dispersible thereinto, and accordingly, is preferable as the electrode material. Note that the light transmittance in the visible light range must be decided in consideration for a relationship between a film thickness and light absorption amount of each π-conjugated substance.

Specifically, in the organic electroluminescent element of the present invention, at least one of the first electrode and the second electrode is any of the metal thin film, the oxide thin film, and the organic material thin film. Then, it is preferable that the metal thin film be formed of at least one element selected from among Au, Ag, Cu, Ni, Cr, Zn, In, Al, Sn, Pb, Pt, Pd, Ti, and the mixtures thereof. It is preferable that the oxide thin film be formed of at least one selected from among tin oxide, indium tin oxide, zinc oxide, and the composites thereof. Moreover, it is preferable that the organic material thin film be formed of the material containing the π-conjugated substance. Specifically, it is preferable that the above-described π-conjugated substance be the polymer soluble in the water or the organic solvent, and in detail, it is preferable that the π-conjugated substance be at least one selected from polypyrrole, polyaniline, polythiophene, polyacetylene, polyisothianaphthene, and the derivatives thereof, which are subjected to the doping treatment, or at least one selected from among polyethylenedioxythiophene, polypropylene oxide, and the derivatives thereof.

Moreover, for an organic material thin film made of other than the above-described π-conjugated substance, a material containing conductive nanoparticles and polymer resin having the light transmittance may be used. As the conductive nanoparticles, for example, there can be mentioned one of an element selected from among Au, Ag, Pt, Pd, Ni, Cu, Zn, Al, Sn, Pb, C, and Ti, or a compound containing an element selected from thereamong. It is preferable to set a particle diameter of the conductive nanoparticles roughly to 50 nm or less. When the particle diameter is set at 50 nm or less, the particle diameter of the conductive nanoparticles becomes smaller than the wavelength λ (380 to 780 nm) of the incident light in the visible light range, and the light transmittance is increased. Note that a shape of the conductive nanoparticles is not limited to the illustrated particulate shape, and may be needle-like and stick-like. In order to exhibit the light transmittance as described above, dispersibility of the conductive nanoparticles in the polymer resin becomes extremely important. When the conductive nanoparticles are mutually coagulated, the particle diameter thereof becomes larger, and the size thereof does not reach the size of the above-described wavelength λ of the incident light or less. Accordingly, the light transmittance is damaged by a scattering function that is based on the Rayleigh scattering and the Mie scattering. Moreover, roughness of the electrode surface is also increased. Furthermore, in any transparent electrode made of the metal thin film, the oxide thin film, and the organic material thin film, a film thickness thereof should be decided based on the balance between the light transmittance and the surface resistivity, and is not uniquely decided. However, roughly speaking, a film thickness of several ten nanometers to several hundred nanometers is at a practical level.

When the emission light is emitted to the outside of the element as in the organic EL element, it is preferable to increase a light transmittance of the substrate. As a substrate material that is highly light-transmittable, there can be mentioned glass, ceramics, and polymer resin. Note that a shape of such a substrate material is not particularly limited, and may be plate-like, film-like, linear, and variously three-dimensional.

Note that, with regard to a light transmittance of the substrate, it is also necessary to set the transmittance of the substrate in consideration for a thickness and surface flatness of the substrate, and further, for the transmittances, reflectances and absorptions of all the materials composing these elements. Light reflections on front and back surfaces of the substrate itself are generated by approximately 8% to 10% in total. Accordingly, preferably, an average transmittance of the substrate in the visible light range is set at 80% or more, more preferably, 85% or more. When the average light transmittance of the substrate is increased, a loss caused by the scattering and absorption of the light can be reduced to the minimum, and accordingly, the light generated from the organic light-emitting layer can be efficiently emitted through the substrate to the outside.

With regard to the substrate, besides the above-described light transmittance, anisotropy of a refractive index in the polymer resin also becomes a problem. This is because, when the anisotropy of the refractive index occurs, this affects an emitting direction of the light. Specifically, when birefringence Δn exceeds 0.1, it becomes difficult to emit the light to a required direction, resulting in an optical loss, and this is not preferable in practical use. Accordingly, it is preferable that the birefringence be set at 0.1 or less. Moreover, when the organic EL element is formed into a curved surface or a three-dimensional shape, flexibility of the substrate is required, and accordingly, it is preferable that the substrate be formed of a polymer resin film. As such a polymer resin film having the light transmittance, which is applicable to the substrate, there can be mentioned one selected from among polyethylene terephthalate (PET), polyethylene naphthalate (PEN), polycarbonate (PC), polymethylmethacrylate (PMMA), polyethersulfone (PES), and derivatives thereof.

### (Surface Treatment Method)

Next, a description will be made of a surface treatment method according to the embodiment of the present invention. Note that this surface treatment method is a method for forming the above-described ion-doped surface.

In the surface treatment method of the present invention, the acidic solution containing the hydrogen ions or the alkaline solution containing the hydroxide ions is adhered onto the electrode surface, the hydrogen ions or the hydroxide ions are doped onto the surface of the electrode, and the ionization potential of the electrode surface is controlled.

Describing in more detail, first, the surface of the substrate (of glass, ceramics, polymer resin, or the like) having the light transmittance is cleaned. As a cleaning method of the surface, a publicly known method can be used, and for example, there can be mentioned degreasing by a neutral detergent, and ultrasonic cleaning by an organic solvent (ethyl alcohol and the like).

After the surface of the substrate is cleaned, a PEDOT:PSS (of which ratio is 1: 1.6) solution as the material of the transparent electrode is coated on the surface of the substrate by a thin-film forming method, thereafter, heat treatment is performed to cure the solution, and the transparent electrode is formed on the substrate having the light transparency. Here, a wet method should be used as the thin-film forming method, and as the wet method, there can be mentioned the casting method, the spin-coat method, the dip method, the spray method, and various printing methods (ink-jet method, gravure printing method, screen printing method). For example, in the case of using the spin-coat method, an appropriate amount of the PEDOT:PSS (of which ratio is 1: 1.6) solution is dropped onto the glass substrate under the room temperature, and thereafter, a film with a predetermined thickness is formed by a spin coater while arbitrarily setting the number of revolutions thereof (for example, at 1,500 rpm). Thereafter, under the atmospheric pressure, the heat treatment for 10 minutes is performed at 200°C to cure the solution. In such way, the transparent electrode as the PEDOT:PSS thin film can be formed on the glass substrate. Note that it is preferable to use the printing method in terms of the industrial production. In this case, after the electrode is pattern-printed on the substrate, the solution is cured, thus making it possible to form a transparent electrode pattern on the substrate.

Moreover, the acidic solution containing the hydrogen ions or the solution containing the hydroxide ions is prepared, and into the solution, the substrate on which the transparent electrode is formed is immersed for several seconds to several hundred seconds. In such a way, either the hydrogen ions or the hydroxide ions are ion-doped onto the surface of the transparent electrode. Thereafter, the treated surface is subjected to rinsing treatment by ultrapure water, and thereafter, is subjected to heat treatment at 200°C for 20 minutes, and an ion-doped surface is thereby formed on the surface of the transparent electrode. In such a way, a series of the treatments is completed. For example, the immersion time when the H₂SO₄ solution is used as the acidic solution should be approximately 600 seconds, and the immersion time when the NaOH solution is used as the alkaline solution should be approximately 15 seconds. Note that treatment conditions (treatment solution concentration, immersion time, temperature) when the ions are doped should be appropriately set in response to the material, thickness, surface roughness or the like of the electrode or the organic light-emitting layer. Note that the above-described "immersion" incorporates a meaning that a surface of a sample is simply wetted by the acidic solution or the alkaline solution.

In accordance with the surface treatment method described above, there can be obtained a member including the electrode and the organic light-emitting layer, and further including the ion-doped surface in which either the hydrogen ions or the hydroxide ions are doped in the vicinity of the contact interface between the electrode and the organic light-emitting layer.

In the surface treatment of the present invention, not only the ionization potential of the surface of the electrode or the organic light-emitting layer can be arbitrarily controlled, but also it becomes possible to decrease the surface resistivity (increase the conductivity). A description will be made that the surface treatment method of the present invention can be extended to other various purposes.

The present invention is applied to the element represented by the organic EL element, the solar battery, the light modulation element, and the transistor (FET element). A point of the present invention is in that motions of the carriers (electrons, holes) on a bonded interface between different types of materials are positively utilized. It is obvious that the treatment method of the present invention is extremely effective for such an element as described above and a unit (aggregate) using the same. For example, when the present invention is extended to the organic EL element and a display member using the same, in addition to performance enhancements such as voltage reduction, lifetime elongation, and transmittance enhancement, it becomes possible to reduce the materials for use, to simplify the manufacturing process, and further, to reduce cost in the future by applying an all-wet process.

### (Manufacturing Method of Organic EL element)

A description will be made of a manufacturing method of the organic EL element according to the embodiment of the present invention.

In the manufacturing method of the organic EL element according to the first invention, first, the surface of the substrate is cleaned. A cleaning method of the substrate is similar to the above-described method. After the cleaning, the first electrode is formed on the substrate. Specifically, the first electrode is formed by a wet thin-film forming method by using a material containing the π-conjugated substance soluble in the water or the organic solvent, and the first electrode is made as the above-described member. Here, the wet thin-film forming method is also similar to the above-described method.

Next, the ion-doped surface is formed, in which either the hydrogen ions or the hydroxide ions are doped onto the first electrode surface of the member. As a method of doping the hydrogen ions or the hydroxide ions, there can be employed a method of adhering the acidic solution containing the hydrogen ions or the alkaline solution containing the hydroxide ions onto the member. As a method of adhering the acidic solution or the alkaline solution onto the member, there can be mentioned a method of immersing the member into the solution, or exposing the member to an atmospheric gas thereof. For example, in the case of using, as the acidic solution, a solution containing the proton acid (H₂SO₄, HCl, HNO₃, HF, HClO₃, FSO₃H, CH₃SO₃H) or the Lewis acid (BF₃, PF₅, AsF₅, SbF₅, SO₃), it is preferable to set the solution concentration pH thereof at 0.5 to 6.5, and to perform the acidic treatment. Meanwhile, in the case of using, as the alkaline solution, a solution containing at least one selected from among NaOH, KOH, NH₃, and the derivatives thereof, it is preferable to set the solution concentration pH thereof at 7.5 to 12.0, and to perform the alkaline treatment.

Thereafter, the surface subjected to the acidic treatment or the alkaline treatment as described above is washed and dried, and thereafter, the organic light-emitting layer is formed on the first electrode on which the ion-doped surface is formed. Specifically, the organic light-emitting layer is formed by using the wet thin-film forming method by using the material containing the π-conjugated substance soluble in the water or the organic solvent.

Moreover, the second electrode is formed on the organic light-emitting layer, and the organic EL element is made. Specifically, the second electrode is formed by the wet thin-film forming method by using the material containing the π-conjugated substance soluble in the water or the organic solvent.

In accordance with the above-described manufacturing method of the organic EL element, the formation of the electrodes (anode, cathode) and the organic light-emitting layer and the ion doping treatment can be brought together into a continuous wet process. Therefore, in comparison with the conventional vacuum evaporation method, the manufacturing process can be simplified, and further, the cost can be reduced to a large extent.

Specifically, the manufacturing method of the organic electroluminescent element according to the present invention is characterized in that the first electrode is the anode, the hydrogen ions are doped in the doping step, and further, the solution is at least one solution selected from among the proton acid, the Lewis acid, and the mixture thereof. Moreover, preferably, the proton acid is at least one selected from among H₂SO₄, HCl, HNO₃, HF, HClO₃, FSO₃H, and CH₃SO₃H, the Lewis acid is at least one selected from BF₃, PF₅, AsF₅, SbF₅, and SO₃, and the concentration pH of the solution is 0.5 to 6.5. Moreover, another manufacturing method of the organic electroluminescent element according to the present invention is characterized in that the first electrode is the cathode, the hydroxide ions are doped in the doping step, and further, the solution is at least one solution selected from among NaOH, KOH, NH₃, and the derivatives thereof. Then, preferably, the concentration pH of the solution is 7.5 to 12.0.

Moreover, preferably, the first electrode is formed by the wet thin-film forming method by using the material containing the π-conjugated substance soluble in the water or the organic solvent, the organic light-emitting layer is formed by the wet thin-film forming method by using the material containing the π-conjugated substance soluble in the water or the organic solvent, and the second electrode is formed by the wet thin-film forming method by using the material containing the π-conjugated substance soluble in the water or the organic solvent. Furthermore, in the doping step, preferably, the substrate and the first electrode are immersed into the solution, whereby the solution is adhered onto the surface of the first electrode, and preferably, the step of washing and drying the surface of the first electrode is provided after the doping step and before the forming step of the organic light-emitting layer.

Moreover, the organic EL element manufacturing by the above-described manufacturing method can be driven at a low voltage since the ion-doped surface is provided between the electrode and the organic light-emitting layer in order to control the potential barrier. As a result, the long lifetime of the organic EL element can be realized. Furthermore, when the substrate or the electrode in the organic EL eminent is composed of the above-described transparent material having the high light transmittance, the emitting direction of the light can be arbitrarily set. As a result, it also becomes possible to apply the organic EL element as the display member and an illumination member by selecting the composition materials in response to the usage purpose.

A description will be specifically made below of the present invention by using Examples; however, the present invention is not limited to the illustrated

### Examples.

### (Example 1-1)

First, a quartz glass substrate was subjected to ultrasonic washing by ethyl alcohol, thereafter, an appropriate amount of the PEDOT:PSS (of which ratio was 1: 1.6) was dropped onto the glass substrate under the room temperature, and was coated thereon by the spin coater with the number of revolutions of 1,500 rpm. In such a way, a thin film was formed. Thereafter, the thin film was subjected to heat treatment at 200°C for 10 minutes, and was cured. In such a way, a member A was obtained, in which a transparent electrode with a film thickness of 100 nm was formed on the glass substrate.

Next, an acidic solution of H₂SO₄ with a solution concentration pH of 5.0 was prepared, the member A was immersed into the acidic solution of H₂SO₄, and the hydrogen ions were doped onto a surface of the member A. Thereafter, the surface of the member A was subjected to rinsing treatment by ultrapure water five times, and the member A was subjected to heat treatment at 200°C for 600 seconds. In such a way, a sample was made, in which an ion-doped surface was formed on the transparent electrode of the member A.

### (Example 1-2 to Example 1-5)

In Example 1-2 to Example 1-5, samples in each of which the ion-doped surface was formed on the transparent electrode were made by using a similar method to that of Example 1-1 except that the concentration pH of the acidic solution of H₂SO₄ was changed at the time of the treatment by the acidic solution. The concentrations of the acidic solutions of H₂SO₄ in Example 1-2 to Example 1-5 were sequentially set at pH 3.0, pH 1.3, pH 0.6, and pH 0.2.

### (Comparative example 1)

In Comparative example 1, the member A made in Example 1-1 without performing the treatment by the acidic solution was used as a sample.

### (Example 2-1)

In Example 2-1, a sample in which the ion-doped surface was formed on the transparent electrode was made by using a similar method to that of Example 1-1 except that an acidic solution of HCl with the concentration pH of 5.0 was used at the time of the treatment by the acidic solution.

### (Example 2-2 to Example 2-5)

In Example 2-2 to Example 2-5, samples in each of which the ion-doped surface was formed on the transparent electrode were made by using a similar method to that of Example 2-1 except that the concentration pH of the acidic solution of HCl was changed at the time of the treatment by the acidic solution. The concentrations pH of the acidic solutions of HCl in Example 2-2 to Example 2-5 were sequentially set at pH 3.0, pH 1.3, pH 0.6, and pH 0.2.

### (Comparative example 2)

In Comparative example 2, the member A made by using a similar method to that of Example 1-1 without performing the treatment by the acidic solution was used as a sample.

### (Example 3-1)

In Example 3-1, a sample in which the ion-doped surface was formed on the transparent electrode was made by using a similar method to that of Example 1-1 except that an acidic solution of CH₃SO₃H with the solution concentration pH of 5.0 was used at the time of the treatment by the acidic solution.

### (Example 3-2 to Example 3-5)

In Example 3-2 to Example 3-5, samples in each of which the ion-doped surface was formed on the transparent electrode were made by using a similar method to that of Example 3-1 except that the concentration pH of the acidic solution of CH₃SO₃H was changed at the time of the treatment by the acidic solution. The concentrations pH of the acidic solutions of CH₃SO₃H in Example 3-2 to Example 3-5 were sequentially set at pH 3.0, pH 1.3, and pH 0.2.

### (Comparative example 3)

In Comparative example 3, the member A made by using a similar method to that of Example 1-1 without performing the treatment by the acidic solution was used as a sample.

### (Example 4-1)

In Example 4-1, a sample in which the ion-doped surface was formed on the transparent electrode was made by using a similar method to that of Example 1-1 except that an acidic solution of BF₃ with the solution concentration pH of 5.0 was used at the time of the treatment by the acidic solution.

### (Example 4-2, Example 4-3)

In Example 4-2 and Example 4-3, samples in each of which the ion-doped surface was formed on the transparent electrode were made by using a similar method to that of Example 4-1 except that the concentration pH of the acidic solution of BF₃ was changed at the time of the treatment by the acidic solution. The concentrations of the acidic solutions of BF₃ in Example 4-2 and Example 4-3 were sequentially set at pH 3.0 and pH 1.3.

### (Comparative example 4)

In Comparative example 4, the member A made by using a similar method to that of Example 1-1 without performing the treatment by the acidic solution was used as a sample.

### (Example 5-1)

In Example 5-1, first, the member A was made by using a similar method to that of Example 1-1.

Next, an alkaline solution of NaOH with the solution concentration pH of 7.5 was prepared. Then, the member A was immersed into the alkaline solution of NaOH for 15 seconds, and the hydroxide ions were doped onto the surface of the member A. Thereafter, the surface of the member A was subjected to rinsing treatment by ultrapure water five times, and the member A was subjected to heat treatment at 200°C for 600 seconds. In such a way, a sample was made, in which an ion-doped surface was formed on the transparent electrode of the member A.

### (Example 5-2, Example 5-3)

In Example 5-2 and Example 5-3, samples in each of which the ion-doped surface was formed on the transparent electrode were made by using a similar method to that of Example 5-1 except that the concentration pH of the alkaline solution of NaOH was changed at the time of the treatment by the acidic solution. The concentrations of the alkaline solutions of NaOH in Example 5-2 and Example 5-3 were sequentially set at pH 10.0 and pH 12.1.

### (Comparative example 5)

In Comparative example 5, the member A made by using a similar method to that of Example 1-1 without performing the treatment by the alkaline solution was used as a sample.

### (Example 6-1)

In Example 6-1, a sample in which the ion-doped surface was formed on the transparent electrode was made by using a similar method to that of Example 5-1 except that an alkaline solution of NH₃ with the solution concentration pH of 7.2 was used at the time of the treatment by the alkaline solution.

### (Example 6-2, Example 6-3)

In Example 6-2 and Example 6-3, samples in each of which the ion-doped surface was formed on the transparent electrode were made by using a similar method to that of Example 6-1 except that the concentration pH of the alkaline solution of NH₃ was changed at the time of the treatment by the alkaline solution. The concentrations of the alkaline solutions of NH₃ in Example 6-2 and Example 6-3 were sequentially set at pH 10.0 and pH 12.1.

### (Comparative example 6)

In Comparative example 6, the member A made by using a similar method to that of Example 1-1 without performing the treatment by the alkaline solution was used as a sample.

### (Example 7-1)

First, a quartz glass substrate was subjected to ultrasonic washing by ethyl alcohol, and thereafter, an ITO thin film was formed on the glass substrate by using the magnetron sputtering method. In such a way, a member B was obtained, in which a transparent electrode with a film thickness of 100 nm was formed on the glass substrate.

Thereafter, the member B was immersed into an alkaline solution of NaOH with the solution concentration pH of 7.5, and a sample in which an ion-doped surface was formed on the transparent electrode was made by using a similar method to that of Example 5-1.

### (Example 7-2)

In Example 7-2, a sample in which the ion-doped surface was formed on the transparent electrode was made by using a similar method to that of Example 7-1 except that the concentration pH of the alkaline solution of NaOH was changed to 12.0 at the time of the treatment by the alkaline solution.

### (Comparative example 7)

In Comparative example 7, the member B made by using a similar method to that of Example 7-1 without performing the treatment by the alkaline solution was used as a sample.

### (Example 8)

First, a quartz glass substrate was subjected to ultrasonic washing by ethyl alcohol, and thereafter, an Au thin film was formed on the glass substrate by using the vacuum evaporation method. In such a way, a member C was obtained, in which a transparent electrode with a film thickness of 100 nm was formed on the glass substrate.

Thereafter, the member C was immersed into an alkaline solution of NaOH with the solution concentration pH of 10.0, and a sample in which an ion-doped surface was formed on the transparent electrode was made by using a similar method to that of Example 5-1.

### (Comparative example 8)

In Comparative example 8, a member A made by using a similar method to that of Example 8 without performing the treatment by the alkaline solution was used as a sample.

For the respective samples made according to the above-described Example 1 to Example 8 and Comparative example 1 to Comparative example 8, the ionization potentials were measured in the atmosphere by using the photoelectric spectrometer (AC-2, made by Riken Keiki Co., Ltd.). Moreover, the resistivities of the respective samples were actually measured by the 4-point probe method (JIS K7194).

Measurement results of the respective samples of Example 1 to Example 4 and Comparative example 1 to Comparative example 4 are shown in Table 1, and measurement results of the respective samples of Example 5 to Example 8 and Comparative example 8 are shown in Table 2. Note that the ionization potentials of the respective Examples treated by the acidic solutions were defined as Ip₂, the ionization potentials of the respective Examples treated by the alkaline solutions were defined as Ip₃, and the ionization potentials of the members A, the members B, and the member C, which are not treated by the acidic solutions or the alkaline solutions, were defined as Ip₁.

**Table 1**

| | | Substrate | Electrode | Treatment by acidic solution containing hydrogen ions | | | Ionization potential Iₚ₁ (eV) | Ionization potential Iₚ₂ (eV) | Iₚ₂-Iₚ₁ (eV) | Resistivity (Ω·cm) |
|---|---|---|---|---|---|---|---|---|---|---|
| | | | | Type of acidic solution | Concentration (pH) | Treatment time (sec) | | | | |
| Example | 1-1 | Quartz glass | PEDOT:PSS | H₂SO₄ | 5.0 | 600 | - | 5.15 | 0.03 | 1.2 |
| | 1-2 | Quartz glass | PEDOT:PSS | H₂SO₄ | 3.0 | 600 | - | 5.19 | 0.07 | 0.64 |
| | 1-3 | Quartz glass | PEDOT:PSS | H₂SO₄ | 1.3 | 600 | - | 5.28 | 0.16 | 0.41 |
| | 1-4 | Quartz glass | PEDOT:PSS | H₂SO₄ | 0.6 | 600 | - | 5.36 | 0.24 | 0.02 |
| | 1-5 | Quartz glass | PEDOT:PSS | H₂SO₄ | 0.2 | 600 | - | 5.49 | 0.37 | 0.008 |
| Comparative example 1 | | Quartz glass | PEDOT:PSS | - | - | - | 5.12 | - | - | 3.0 |
| Example | 2-1 | Quartz glass | PEDOT:PSS | HCl | 5.0 | 600 | - | 5.05 | 0.01 | 1.4 |
| | 2-2 | Quartz glass | PEDOT:PSS | HCl | 3.0 | 600 | - | 5.14 | 0.1 | 0.66 |
| | 2-3 | Quartz glass | PEDOT:PSS | HCl | 1.3 | 600 | - | 5.18 | 0.06 | 0.52 |
| | 2-4 | Quartz glass | PEDOT:PSS | HCl | 0.6 | 600 | - | 5.21 | 0.17 | 0.46 |
| | 2-5 | Quartz glass | PEDOT:PSS | HCl | 0.2 | 600 | - | 5.20 | 0.16 | 0.38 |
| Comparative example 2 | | Quartz glass | PEDOT:PSS | - | - | - | 5.04 | - | - | 2.5 |
| Example | 3-1 | Quartz glass | PEDOT:PSS | CH₃SO₃H | 5.0 | 600 | - | 5.13 | 0.03 | 1.2 |
| | 3-2 | Quartz glass | PEDOT:PSS | CH₃SO₃H | 3.0 | 600 | - | 5.21 | 0.11 | 0.51 |
| | 3-3 | Quartz glass | PEDOT:PSS | CH₃SO₃H | 1.3 | 600 | - | 5.36 | 0.24 | 0.36 |
| | 3-4 | Quartz glass | PEDOT:PSS | CH₃SO₃H | 0.2 | 600 | - | 5.61 | 0.51 | 0.006 |
| Comparative example 3 | | Quartz glass | PEDOT:PSS | - | - | - | 5.10 | - | - | 2.8 |
| Example | 4-1 | Quartz glass | PEDOT:PSS | BF₃ | 5.0 | 600 | - | 5.15 | 0.03 | 1.1 |
| | 4-2 | Quartz glass | PEDOT:PSS | BF₃ | 3.0 | 600 | - | 5.26 | 0.13 | 0.46 |
| | 4-3 | Quartz glass | PEDOT:PSS | BF₃ | 1.3 | 600 | - | 5.33 | 0.21 | 0.29 |
| Comparative example 4 | | Quartz glass | PEDOT:PSS | - | - | - | 5.12 | - | - | 2.6 |

**Table 2**

| | | Substrate | Electrode | Treatment by alkaline solution containing hydroxide ions | | | Ionization potential Iₚ₁ (eV) | Ionization potential Iₚ₃ (eV) | Iₚ₃-Iₚ₁ (eV) | Resistivity (Ω·cm) |
|---|---|---|---|---|---|---|---|---|---|---|
| | | | | Type of alkaline solution | Concentration (pH) | Treatment time (sec) | | | | |
| Example | 5-1 | Quartz glass | PEDOT:PSS | NaOH | 7.5 | 15 | - | 5.09 | -0.06 | 1.2 |
| | 5-2 | Quartz glass | PEDOT:PSS | NaOH | 10.0 | 15 | - | 5.10 | -0.54 | 1.4 |
| | 5-3 | Quartz glass | PEDOT:PSS | NaOH | 12.1 | 15 | - | 4.62 | -0.54 | 5.5 |
| Comparative example 5 | | Quartz glass | PEDOT:PSS | - | - | - | 5.16 | - | - | 3.1 |
| Example | 6-1 | Quartz glass | PEDOT:PSS | NH₃ | 7.5 | 15 | - | 5.11 | -0.05 | 1.3 |
| | 6-2 | Quartz glass | PEDOT:PSS | NH₃ | 10.0 | 15 | - | 5.04 | -0.12 | 2.0 |
| | 6-3 | Quartz glass | PEDOT:PSS | NH₃ | 12.0 | 15 | - | 5.03 | -0.13 | 2.9 |
| Comparative example 6 | | Quartz glass | PEDOT:PSS | - | - | - | 5.16 | - | - | 3.4 |
| Example | 7-1 | Quartz glass | ITO | NaOH | 7.5 | 15 | - | 4.92 | -0.09 | 0.08 |
| | 7-2 | Quartz glass | ITO | NaOH | 12.0 | 15 | - | 4.60 | -0.41 | 1.9 |
| Comparative example 7 | | Quartz glass | ITO | - | - | - | 5.01 | - | - | 1.2 |
| Example | 8-1 | Quartz glass | Au | NaOH | 10.0 | 15 | - | 4.61 | -0.07 | 0.001 |
| Comparative example 8 | | Quartz glass | Au | - | - | - | 4.68 | - | - | 0.002 |

Note that, in Comparative example 1 to comparative example 6, the members A manufactured by using the manufacturing method of Example 1 were used as the samples; however, since trial production dates in the respective Comparative examples are different from one another, the values of the ionization potentials are different from one another. As opposed to this, in the same experimental systems (for example, Example 1-1 to Example 1-5 and Comparative example 1), the sample making was performed in the same day, and comparison was made for the respective Examples and Comparative example. Also in other experimental systems, the trial production date is the same in the same experimental system.

As shown in Table 1, in Examples in which the hydrogen ions were doped, the values of the ionization potentials became larger in comparison with Comparative examples in which the hydrogen ions were not doped. Moreover, Examples showed a tendency that the resistivities also became low and the conductivities became high. In particular, when comparison was made for Example 1-1 to Example 1-5 which were the same experimental systems, a tendency was shown, that the value of the ionization potential became larger as pH of the acidic solution containing the hydrogen ions was being reduced, and further, a tendency was shown, that the value of the resistivity became low and the conductivity became high. It turned out that a similar tendency was shown also in other experimental systems.

Moreover, as shown in Table 2, in Examples in which the hydroxide ions were doped, the values of the ionization potentials became smaller in comparison with Comparative examples in which the hydroxide ions were not doped. In particular, when comparison was made for Example 5-1 to Example 5-3 as the same experimental systems, a tendency was shown, that the value of the ionization potential became lower as pH of the alkaline solution was being increased. It turned out that a similar tendency was shown also in other experimental systems.

The entire contents of Japanese Patent Application 2005-51987 (filing date: February 25, 2005) are incorporated herein by reference.

The description has been made above of the contents of the present invention along the embodiment and the examples; however, it is self-evident for those skilled in the art that the present invention is not limited to the description of these, and that various modifications and improvements are possible.

### INDUSTRIAL APPLICABILITY

In accordance with the organic EL element according the present invention, the ion-doped surface is formed between the electrode and the organic light-emitting layer, and the potential barrier on the contact interface between the electrode and the organic light-emitting layer is controlled. Accordingly, the low-voltage drive is made possible, and the long lifetime can be achieved.

In accordance with the manufacturing method of the organic EL element according to the present invention, the element configuration becomes simple, the manufacturing process is also simple, and the further cost reduction can be achieved.

In accordance with an article using the organic EL element according to the present invention, a low-voltage drive thereof is made possible, and a long lifetime thereof can be achieved.

## Claims

1. An organic electroluminescent element, comprising:
a substrate;
a first electrode formed on the substrate;
an organic light-emitting layer formed on the first electrode to be brought into contact with the first electrode; and
a second electrode formed on the organic light-emitting layer,
wherein an ion-doped surface onto which hydrogen ions or hydroxide ions are doped as dopant is provided in a vicinity of a contact interface between the first electrode and the organic light-emitting layer.

2. The organic electroluminescent element according to claim 1,
wherein, when the hydrogen ions are doped onto molecules on the contact interface, negatively charged anions are adsorbed onto a surface of the first electrode, and an electric double layer is thereby formed, and
when the hydroxide ions are doped onto the molecules on the contact interface, a concentration of the hydroxide ions is increased, and an ionization potential of the first electrode is thereby decreased.

3. The organic electroluminescent element according to any one of claims 1 and 2, wherein the first electrode is an anode, and the hydrogen ions are doped in the vicinity of the contact interface.

4. The organic electroluminescent element according to claim 3, wherein the hydrogen ions are doped by acidic treatment using at least one aqueous solution selected from among aqueous solutions of proton acid, Lewis acid, and a mixture thereof.

5. The organic electroluminescent element according to any one of claims 2 to 4, wherein the hydrogen ions are doped by acidic treatment with a concentration pH of the aqueous solution set at 0.5 to 6.5.

6. The organic electroluminescent element according to any one of claims 2 to 5, wherein, when the ionization potential of the first electrode in which the hydrogen ions are doped is Ip₂, and an ionization potential of the first electrode in which the hydrogen ions are not doped is Ip₁, a difference Ip₂-Ip₁ therebetween is larger than 0.

7. The organic electroluminescent element according to claim 1, wherein the first electrode is a cathode, and the hydroxide ions are doped in the vicinity of the contact interface.

8. The organic electroluminescent element according to claim 7, wherein the hydrogen ions are doped by alkaline treatment using at least one aqueous solution selected from among aqueous solutions of NaOH, KOH, NH₃, and derivatives thereof.

9. The organic electroluminescent element according to any one of claims 7 and 8, wherein the hydroxide ions are doped by alkaline treatment with a concentration pH of the aqueous solution set at 7.5 to 12.0.

10. The organic electroluminescent element according to any one of claims 7 to 9, wherein, when an ionization potential of the first electrode in which the hydroxide ions are doped is Ip₃, and the ionization potential of the first electrode in which the hydrogen ions are not doped is Ip₁, a difference Ip₃-Ip₁ therebetween is smaller than 0.

11. The organic electroluminescent element according to any one of claims 1 to 10, wherein, in at least one of the first electrode and the second electrode, an average light transmittance in a visible light range is 60% or more.

12. The organic electroluminescent element according to any one of claims 1 to 11, wherein at least one of the first electrode and the second electrode is a metal thin film, an oxide thin film, or an organic material thin film.

13. The organic electroluminescent element according to any one of claims 1 to 12, wherein at least one of the first electrode and the second electrode is made of a material containing conductive nanoparticles and polymer resin having the light transmittance.

14. The organic electroluminescent element according to any one of claims 1 to 13, wherein the substrate is one selected from among glass, ceramics, and polymer resin, in which the average light transmittance in the visible light range is 80% or more.

15. The organic electroluminescent element according to claim 14, wherein in-plane birefringence Δn of the polymer resin is 0.1 or less.

16. The organic electroluminescent element according to any one of claims 14 and 15, wherein the polymer resin is one selected from among polyethylene terephthalate, polyethylene naphthalate, polycarbonate, polymethylmethacrylate, polyethersulfone, and derivatives thereof.

17. A manufacturing method of an organic electroluminescent element, comprising:
forming a first electrode on a substrate;
adhering an aqueous solution containing hydrogen ions or hydroxide ions onto the first electrode, and doping the hydrogen ions or the hydroxide ions onto a surface of the first electrode;
forming an organic light-emitting layer on the surface of the first electrode, onto which the hydrogen ions or the hydroxide ions are doped; and
forming a second electrode on the organic light-emitting layer,
wherein, when the hydrogen ions are doped onto molecules on the contact interface, negatively charged anions are adsorbed onto a surface of the first electrode, and an electric double layer is thereby formed, and
when the hydroxide ions are doped onto the molecules on the contact interface, a concentration of the hydroxide ions is increased, and an ionization potential of the first electrode is thereby decreased.

18. A surface treatment method, wherein an electrode is immersed into an acidic solution containing hydrogen ions or into an alkaline solution containing hydroxide ions, the hydrogen ions or the hydroxide ions are doped onto a surface of the electrode, and an ionization potential of the surface of the electrode is thereby controlled.
